# EUROPÄISCHE PATENTSCHRIFT

(11) **EP 1 370 498 B1**
(45) Veröffentlichungstag und Bekanntmachung des Hinweises auf die Patenterteilung: **13.10.2004**
(21) Anmeldenummer: 02753035.1
(22) Anmeldetag: 20.03.2002
(51) Int. Cl.: C03C 17/22, C03C 17/245, C03C 17/34, C30B 15/10

(54) **BAUTEIL AUS QUARZGLAS SOWIE VERFAHREN ZUR HERSTELLUNG DESSELBEN**
QUARTZ GLASS COMPONENT AND METHOD FOR THE PRODUCTION THEREOF
ELEMENT STRUCTURAL EN VERRE DE QUARTZ ET PROCEDE DE FABRICATION DUDIT ELEMENT

(30) Priorität: 23.03.2001 DE 10114698
(43) Veröffentlichungstag der Anmeldung: 17.12.2003
(73) Patentinhaber: Heraeus Quarzglas GmbH & Co. KG, 63450 Hanau (DE)
(72) Erfinder: WERDECKER, Waltraud, 63456 Hanau (DE); GERHARDT, Rolf, 63546 Hammersbach (DE); LEIST, Johann, 63674 Altenstadt (DE)
(74) Vertreter: Staudt, Armin, Dipl.-Ing.
(86) Internationale Anmeldenummer: PCT/EP2002/003118
(87) Internationale Veröffentlichungsnummer: WO 2002/092525

(56) Entgegenhaltungen:
- US-A- 4 395 432

## Beschreibung

Die Erfindung betrifft ein Bauteil aus Quarzglas mit hoher thermischer Stabilität, insbesondere einen Quarzglastiegel, umfassend eine Rohform, von der mindestens ein Teil ihrer Außenoberfläche mit einer Stabilisierungsschicht versehen ist, die eine höhere Erweichungstemperatur als Quarzglas ausweist.

Weiterhin betrifft die Erfindung ein Verfahren zur Herstellung eines Bauteils aus Quarzglas mit hoher thermischer Stabilität, insbesondere eines Quarzglastiegels, indem eine Rohform des Bauteils erzeugt und mindestens ein Teil der Außenoberfläche davon mit einer Stabilisierungsschicht, die eine höhere Erweichungstemperatur als Quarzglas aufweist, versehen wird.

Für Fertigungsprozesse, bei denen es auf hohe Reinheit ankommt, werden häufig Bauteile aus Quarzglas eingesetzt. Die Temperaturstabilität von Quarzglas bildet dabei einen begrenzenden Faktor. Als unterer Erweichungspunkt für Quarzglas werden in der Literatur Temperaturwerte um 1150 °C angegeben. Häufig liegen die erforderlichen Prozesstemperaturen jedoch oberhalb dieser Temperatur, so dass es zu plastischen Verformungen der Quarzglasbauteile kommen kann. Die Schmelztemperatur beim Ziehen eines Einkristalls aus einer Silizium-Schmelze liegt beispielsweise um 1480 °C. Es ist daher vorgeschlagen worden, die thermische Stabilität von Quarzglasbauteilen zu erhöhen, indem diese mit einer Oberflächenschicht aus Cristobalit versehen werden. Der Schmelzpunkt von Cristobalit liegt bei etwa 1720 °C.

Ein derart gestalteter Quarzglastiegel und ein Verfahren zu seiner Herstellung sind aus der EP-A 748 885 bekannt. Die glasige Außenwandung eines handelsüblichen Quarzglastiegels wird mit einer chemischen Lösung behandelt, die Substanzen enthält, die als Keimbildner wirkend die Entglasung von Quarzglas zu Cristobalit fördern können. Als kristallisationsfördernde Substanzen werden Erdalkali-, Bor-, und Phosphorverbindungen vorgeschlagen. Bevorzugt wird Bariumoxid eingesetzt. Beim Aufheizen des Quarzglastiegels während des Einkristall-Ziehverfahrens kristallisiert die so behandelte Wandung unter Bildung von Cristobalit aus. Diese Kristallisation der Außenwandung führt zu einer höheren mechanischen und thermischen Festigkeit des Quarzglastiegels.

Die Kristallisation der Innen- oder Außenwandung ist jedoch nur mit großem Aufwand reproduzierbar, da sowohl die Keimbildung aufgrund der Verteilung der kristallisationsfördernden Substanzen auf der Tiegeloberfläche, als auch das Kristallwachstum kaum kontrollierbar sind. Beim Transport oder dem Handling des Quarzglastiegels können die kristallisationsfördemden Substanzen abgerieben werden. Ob die Kristallisation in der vorgegebenen Art und Weise eintritt ist daher in der Regel nicht vorhersehbar und erst während des Einsatzes des Quarzglastiegels überprüfbar. Die Kristallisation setzt darüberhinaus erst im Verlaufe des Ziehprozesses ein, also in einem Verfahrensstadium, in dem eine plastische Verformung des Quarzglastiegels bereits stattgefunden haben kann.

Bei einem Bauteil und einem Verfahren der eingangs genannten Gattung, wie aus der US-A 4,102,666 bekannt, wird dieser Nachteil weitgehend vermieden. Dort wird vorgeschlagen, zur thermischen Stabilisierung eines Quarzglas-Diffusionsrohres eine Stabilisierungsschicht zu erzeugen, indem Cristobalit-Pulver auf die Außenoberfläche des Rohres aufgesprüht und anschließend mit dieser verschmolzen wird. Beim Verschmelzen bildet sich jedoch naturgemäß aus der kristallinen Phase zumindest teilweise amorphes SiO₂, also Quarzglas. Der Grad der Rückumwandlung in die amorphe Phase ist von der Dauer des Verschmelzungsvorgangs sowie von der Höhe der Verschmelzungstemperatur abhängig und praktisch schwer kontrollierbar. Eine zu wenig verschmolzene Cristobalit-Pulverschicht neigt zum Abblättern und bei einer zu starken Verschmelzung geht wegen der Umwandlung in die amorphe Phase die stabilisierende Wirkung des Cristobalit-Pulvers verloren.

Eine weitere Schwierigkeit ergibt sich beim Einsatz der bekannten Bauteile in Form von Quarzglastiegeln beim Ziehen eines Einkristalls nach dem Czochralski-Verfahren. Bei diesem Verfahren wird ein Impfkristall mit vorgegebener Orientierungsrichtung in die Schmelze eingetaucht und dann langsam hochgezogen. Imptkristall und Schmelze rotieren dabei gegenläufig. Die Oberflächenspannung zwischen Impfkristall und Schmelze bewirkt, dass mit dem Impfkristall auch ein wenig Schmelze abgezogen wird, die allmählich erkaltet und dadurch zu dem stetig weiterwachsenden Einkristall erstarrt. Dabei kann es aber vorkommen, dass der Impfkristall abreißt, so dass der sogenannte "Ansetzprozess" neu begonnen werden muß. Die Zeitspanne bis zum eigentlichen Ziehen des Einkristalls kann mehrere Stunden betragen, so dass sich die Prozeßdauer entsprechend verlängert und die thermische und chemische Belastung für den Quarzglastiegel entsprechend zunimmt.

Der Erfindung liegt die Aufgabe zugrunde, ein Bauteil aus Quarzglas anzugeben, das sich durch hohe mechanische und thermische Festigkeit auszeichnet sowie ein einfaches und kostengünstiges Verfahren für die Herstellung eines solchen Bauteils anzugeben.

Hinsichtlich des Bauteils wird diese Aufgabe ausgehend von dem eingangs beschriebenen Bauteil erfindungsgemäß dadurch gelöst, dass die Stabilisierungsschicht sich in ihrer chemischen Zusammensetzung von Quarzglas unterscheidet, und dass sie durch thermisches Spritzen erzeugt ist.

Das erfindungsgemäße Bauteil umfaßt eine Rohform, von dessen Oberfläche mindestens ein Teil mit einer Stabilisierungsschicht versehen ist, die sich in ihrer chemischen Zusammensetzung von Quarzglas unterscheidet.

Dieser Stabilisierungsschicht kommen zwei Funktionen zu.

Einerseits trägt die Stabilisierungsschicht zur thermischen Stabilität des Bauteils bei. Dies wird zum einen dadurch erreicht, dass sie eine höhere Erweichungstemperatur als Quarzglas aufweist und zum anderen dadurch, dass die Stabilisierungsschicht sich in ihrer chemischen Zusammensetzung von derjenigen des Quarzglases der Rohform unterscheidet. Dabei bewirkt der Unterschied in der chemischen Zusammensetzung, dass sich keine Cristobalitphase oder lediglich eine geringe Menge an Cristobalit-Keimen in der Stabilisierungsschicht bildet, so dass eine Rissbildung und Schwächung des Gefüges durch Cristobalitumwandlung daher vermieden wird.

Es hat sich darüberhinaus gezeigt, dass beim Einsatz des beschichteten Bauteils als Quarzglastiegel zum Ziehen eines Kristalls das sogenannten "Ansetzverhalten" der Schmelze verbessert wird. Das Ansetzen des Kristalls wird durch Schwingungen der Schmelze behindert. Es kann angenommen werden, dass bedingt durch die Änderung der chemischen Zusammensetzung an der Grenzfläche zwischen Rohform und Stabilisierungsschicht das Schwingungsverhaltens des Tiegels verändert wird, so dass der Aufbau einer Resonanzschwingung erschwert oder verhindert und das Ansetzen des Einkristalls erleichtert werden könnte. Da die Stabilisierungsschicht bereits zu Beginn des Ziehprozesses voll ausgebildet ist, tritt diese vorteilhafte Wirkung bereits zu Anfang des Ziehprozesses auf, der für das Ansetzverhalten entscheidend ist.

Weiterhin zeichnet sich die Stabilisierungsschicht dadurch aus, dass sich durch thermisches Spritzen erzeugt ist. Verfahren zur Erzeugung von Schichten mittels thermischem Spritzen sind allgemein bekannt, wobei unter diesem Oberbegriff die folgenden eingeführten Techniken zusammengefasst werden: Flammspritzen, Hochgeschwindigkeitsflammspritzen, Detonationsspritzen, Plasmaspritzen, Lichtbogenspritzen. Durch thermisches Spritzen lassen sich Stabilisierungsschichten mit definierter Struktur, Schichtdicke und Gefüge erzeugen.

Bei dem Bauteil handelt es sich beispielsweise um einen Quarzglastiegel für das Ziehen von Kristallen aus der Schmelze oder um eine Quarzglasglocke für den Einsatz in Reaktoren für die Herstellung von Halbleiterbauelementen oder um Rohre, Platten, usw. Die Stabilisierungsschicht soll im allgemeinen die eigentliche Funktion des Bauteils nicht beeinflussen und wird daher auf einem entsprechend geeigneten Teil der Oberfläche ausgebildet.

Als vorteilhaft hat es sich erwiesen, dass die Stabilisierungsschicht hochschmelzende Oxide, Silikate, Phosphate und/oder Silizide enthält. Eine derartige Stabilisierungsschicht zeichnet sich durch hohe thermische Stabilität und mechanische Festigkeit aus. Durch thermisches Spritzen kann eine derartige Stabilisierungsschicht mit definierter Struktur, Schichtdicke und Gefüge erzeugt werden.

Vorzugsweise enthält die Stabilisierungsschicht Al₂O₃ und/oder Mullit, Hafniumoxid, Tantaloxid, Zirkonsilikat, Molybdändisilizid, Seltenerd-Phosphate und - Oxide. Derartige Schichten lassen sich rissfrei und spaltfrei gleichmäßig auf die Quarzglasoberfläche aufbringen, und sie zeichnen sich durch eine hohe thermische und mechanische Stabilität aus. Als Beispiele für Seltenerd-Phosphate seien Cer- und Yttriumphosphat und als Beispiel für ein Seltenerd-Oxid Zirkonoxid erwähnt.

Zweckmäßigerweise weist die Stabilisierungsschicht eine Schichtstärke im Bereich zwischen 50 µm und 1000 µm auf. Bei Schichtstärken unterhalb von 50 µm ist die stabilisierende Wirkung der Stabilisierungsschicht unzureichend. Bei Schichtdicken oberhalb von 1000 µm besteht die Gefahr von Abplatzungen.

Es hat sich als günstig erwiesen, dass die Stabilisierungsschicht mehrere, aufeinanderfolgende Lagen unterschiedlicher chemischer Zusammensetzung umfasst. Durch mehrere, aufeinanderfolgende Lagen unterschiedlicher Zusammensetzung können die mechanischen und thermischen Eigenschaften der Stabilisierungsschicht an die konkreten Erfordernisse angepasst werden. Außerdem bietet sich dadurch die Möglichkeit, die Unterschiede des Ausdehnungskoeffizienten von Quarzglas und einer äußeren Lage der Stabilisierungsschicht durch eine oder mehrere Zwischenlagen sukzessive anzupassen.

Im Hinblick hierauf hat sich besonders bewährt, dass die Stabilisierungsschicht eine Lage aus Mullit und eine weiter außen liegende Lage aus Al₂O₃ aufweist. Bei Mullit handelt es sich um eine chemische Verbindung aus Siliziumdioxid und Aluminiumoxid, die einen Ausdehnungskoeffizienten aufweist, der zwischen dem von Quarzglas und Al₂O₃ liegt.

Hinsichtlich des Verfahrens wird die oben angegebene Aufgabe ausgehend von dem eingangs genannten Verfahren erfindungsgemäß dadurch gelöst, dass als Stabilisierungsmittel eine Stabilisierungsschicht, die sich in ihrer chemischen Zusammensetzung von Quarzglas unterscheidet durch thermisches Spritzen aufgebracht wird.

Erfindungsgemäß wird auf mindestens einem Teil der Außenoberfläche der Rohform eine Stabilisierungsschicht durch thermisches Spritzen aufgebracht. Das Aufbringen von Schichten mittels thermischem Spritzen ist eine entwickelte Technik, die auf einer Quarzglasoberfläche die Herstellung vollständig integrierter, spaltfreier und gleichmäßiger Schichten ermöglicht, die eine höhere Erweichungstemperatur als Quarzglas aufweisen. Unter dem Begriff "thermisches Spritzen" werden die folgenden eingeführten Techniken zusammengefasst: Flammspritzen, Hochgeschwindigkeitsflammspritzen, Detonationsspritzen, Plasmaspritzen, Lichtbogenspritzen.

Die Stabilisierungsschicht wird durch thermisches Spritzen bereits vor dem ersten bestimmungsgemäßen Einsatz des Bauteils auf der Außenoberfläche des Bauteils aufgebracht. Dadurch wird gewährleistet, dass sich die thermische stabilisierende Wirkung der Stabilisierungsschicht unmittelbar beim Einsatz des Bauteils entfaltet, und sich nicht etwa - wie bei dem oben erwähnten, bekannten Verfahren - erst allmählich während des Einsatzes des Bauteils entwickelt.

Die Wirkungen der Stabilisierungsschicht auf die thermische Stabilität und auf das "Ansetzverhalten" der Schmelze beim Einsatz des Bauteils als Quarzglastiegel sind oben anhand des erfindungsgemäßen Bauteils näher erläutert.

Es hat sich als günstig erwiesen, die Stabilisierungsschicht auf einer Außenoberfläche mit einer mittleren Rauhtiefe Rₐ von mindestens 10 µm aufzubringen. Dadurch wird eine Verzahnung der Stabilisierungsschicht mit der Außenoberfläche erwirkt, und eine besonders gute Haftung der Stabilisierungsschicht auf der Rohform gewährleistet. Die Außenoberfläche kann mechanisch, durch Schleifen, oder Strahlen mit Sand oder CO₂-Pellets oder durch Ätzen aufgerauht werden. Die erforderliche Oberflächenrauheit kann sich aber auch prozessbedingt bei der Herstellung der Rohform ergeben. Der Wert für die Rauhtiefe Rₐ wird entsprechend DIN 4768 ermittelt.

Besonders bewährt hat sich eine Verfahrensweise, bei der die Stabilisierungsschicht durch Plasmaspritzen erzeugt wird. Die Herstellung von Schichten mittels Plasmaspritzen ist eine entwickelte Technik, durch die sich auf einfache Art und Weise hinsichtlich ihrer Dichte, ihrer Dicke und Struktur, definierte Schichten auf der Rohform aufbringen lassen.

In einer alternativen und gleichermaßen bevorzugten Verfahrensvariante wird die Stabilisierungsschicht durch Flammspritzen erzeugt. Auch hierdurch lassen sich definierte Schichten auf der Rohform reproduzierbar erzeugen, wobei das Ausgangsmaterial für die Stabilisierungsschicht beim Flammspritzen in Pulverform oder in Drahtform vorliegen kann.

Als günstig hat es sich erwiesen, eine Oxide und/oder Silikate, Phosphate, Silizide enthaltende Stabilisierungsschicht zu erzeugen. Vorzugsweise enthält die Stabilisierungsschicht Al₂O₃ und/oder Mullit, Hafniumoxid, Tantaloxid, Zirkonsilikat, Molybdändisilizid, Seltenerd-Phosphate, Seltenerd-Oxide. Es handelt sich dabei um hochschmelzende Substanzen, die zur thermischen Stabilität der Stabilisierungsschicht beitragen. Als Seltenerd-Phosphate werden bevorzugt Cerphosphat (Schmelzpunkt 2045°C) und Yttriumphosphat (Schmelzpunkt 1995°C) eingesetzt.

Zweckmäßigerweise wird eine Stabilisierungsschicht mit einer Schichtstärke im Bereich zwischen 50 µm und 1000 µm erzeugt. Bei einer Schichtstärke von weniger als 50 µm macht sich die stabilisierende Wirkung der Stabilisierungsschicht nicht ausreichend bemerkbar, während Schichten mit einer Schichtstärke von mehr als 1000 µm zu thermischen Spannungen führen können und überdies aus wirtschaftlichen Erwägungen ungünstig sind.

Besonders bevorzugt wird eine Verfahrensvariante, bei als Ausgangsmaterial zur Erzeugung der Stabilisierungsschicht ein Kompositpulver eingesetzt wird. Bei dem Kompositpulver kann es sich beispielsweise um ein Pulver handeln, bei dem ein erstes Material von einem zweiten Material umschlossen und von diesem nach außen abgeschirmt ist. Durch diese Abschirmung ist es beispielsweise möglich, als erstes, inneres Material eine Substanz einzusetzen, die ansonsten beim Plasmaspritzen oder beim Flammspritzen sublimieren würde. Als Beispiel für derartig leicht sublimierende Substanzen seien Nitride, wie Siliziumnitrid, genannt.

Als besonders günstig hat es sich auch erwiesen, zur Erzeugung der Stabilisierungsschicht mindestens zwei Ausgangsmaterialien mit unterschiedlicher chemischer Zusammensetzung einzusetzen. Dadurch lässt sich die chemische Zusammensetzung und damit die chemischen und physikalischen Eigenschaften der Stabilisierungsschicht besonders einfach variieren. Beispielsweise kann ein Gradient im Ausdehnungskoeffizienten eingestellt werden.

Es hat sich als günstig erwiesen, zum Erzeugen der Stabilisierungsschicht mehrere aufeinanderfolgende Lagen mit unterschiedlicher chemischer Zusammensetzung auf der Außenoberfläche aufzubringen. Durch diese Verfahrensvariante lassen sich beispielsweise Unterschiede der Ausdehnungskoeffizienten zwischen dem Quarzglas der Rohform und einer weiter außenliegenden Lage der Stabilisierungsschicht sukzessive überbrücken. Im Hinblick hierauf hat es sich besonders bewährt, eine Mullitschicht zu erzeugen, die von einer Al₂O₃-Schicht umgeben ist.

Nachfolgend wird die Erfindung anhand von Ausführungsbeispielen und einer Patentzeichnung näher erläutert. In der Zeichnung zeigen im einzelnen in schematischer Darstellung
- **Figur 1**: einen Schnitt durch die Wandung eines Quarzglastiegels mit Stabilisierungsschicht,
- **Figur 2**: ausschnittsweise einen Schnitt durch die Wandung eines Quarzglasrohrs mit Stabilisierungsschicht, und
- **Figur 3**: eine zur Durchführung des erfindungsgemäßen Verfahrens geeignete Vorrichtung.

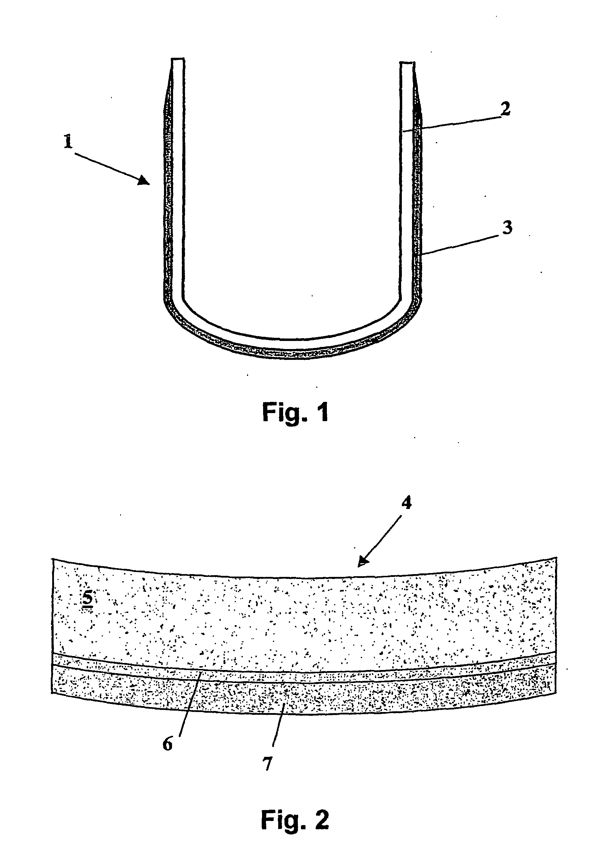

In den Figuren 1 bis 3 sind die für die Erfindung wesentlichen Stabilisierungsschichten zum Zweck einer deutlichen Darstellung in ihrer Dicke hervorgehoben; die Darstellungen sind daher nicht maßstabsgetreu.

in **Figur 1** ist die Bezugsziffer 1 einem Tiegel insgesamt zugeordnet. Der Tiegel 1 besteht aus einer Rohform 2 aus opakem Quarzglas, deren Außenwandung im Bodenbereich des Tiegels 1 und im Seitenbereich mit einer dichten, rissfreien Al₂O₃-Schicht 3 versehen ist. Die Al₂O₃-Schicht 3 hat eine mittlere Dicke von etwa 500 µm.

Nachfolgend wird ein Ausführungsbeispiel für das erfindungsgemäße Verfahren anhand der Herstellung des Tiegels 1 gemäß Figur 1 näher erläutert.

In einem ersten Verfahrensschritt eine Rohform des Quarzglastiegels nach dem bekannten Verfahren hergestellt. Hierzu wird Körnung aus natürlichem Quarz in eine um ihre Mittelachse rotierende metallische Schmelzform gefüllt, mittels einer Andrehschablone an der Innenseite der Schmelzform eine gleichmäßig dicke Quarzkörnungs-Schicht geformt, die aufgrund von Zentrifugalkräften an der Innenwandung stabilisiert wird, und die unter anhaltender Rotation mittels eines Lichtbogens erschmolzen wird, der von oben in die Schmelzform abgesenkt wird. Die Quarzkömungs-Schicht schmilzt dabei unter Bildung der in Figur 1 gezeigten Rohform 2 auf.

Die so hergestellte Rohform 2 weist eine dichte innere Oberflächenschicht auf, die sich durch eine hohe mechanische, thermische und chemische Festigkeit auszeichnet. Die Außenwandung der Rohform 2 wird von anhaftender Quarzkörnung befreit und anschließend abgeschliffen, so dass ich eine mittlere Rauhtiefe Rₐ von etwa 50 µm ergibt.

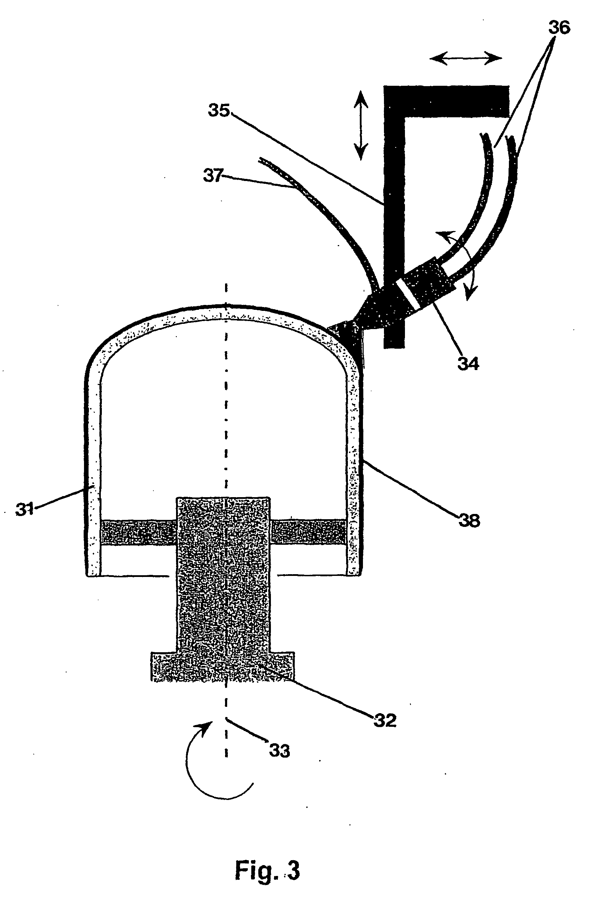

In einem zweiten Verfahrensschritt wird auf der so präparierten Außenwandung der Rohform mittels Plasmaspritzen die Al₂O₃-Schicht 3 erzeugt. Hierzu wird der Tiegel 1 auf einer in den Tiegel 1 eingreifenden und um eine Drehachse rotierbaren Haltevorrichtung montiert, wie sie weiter unten anhand Figur 3 näher erläutert wird. Unter Rotation des Tiegels 1 um seine Mittelachse wird auf der Außenwandung mittels einer handelsüblichen Plasmaspritzpistole Al₂O₃ aufgesprüht. Die Düse der Plasmaspritzpistole wird durch eine in Richtung der Düsenöffnung spitz zulaufende Kathode, die von einer zylindrischen Anode umgeben ist, gebildet. Das Beschichtungsmaterial wird der Düse in Form von feinteiligem Al₂O₃ zugeführt und mittels des Plasmagases (Argon mit einem Zusatz von Wasserstoff) in einer Bogenentladung mit Stromdichten von ca. 100 A/mm² ionisiert, verdampft oder aufgeschmolzen und mit hoher Geschwindigkeit in Richtung auf die Tiegel-Außenwandung gespritzt. Die Temperatur im Plasma erreicht Werte um 20.000 °C, nimmt aber nach außen rasch ab. Mittels des Plasmastrahls werden die verdampften, geschmolzenen und ionisierten Teilchen auf die Tiegel-Außenwandung aufgeschleudert, wo sie erstarren und eine dicke, fest in sich gebundene Al₂O₃ - Beschichtung bilden. Das Plasmaspritzen wird beendet, sobald eine annähernd gleichmäßige Schichtdicke der Al₂O₃-Beschichtung von etwa 500 µm erreicht ist.

Das Quarzglas-Rohr 4 gemäß **Figur 2** weist eine die Innenbohrung umschließende Basisschicht 5 aus opakem Quarzglas auf, die von einer Mullitschicht 6 und diese von einer Al₂O₃-Schicht 7 umgeben ist. Die Mullitschicht 6 hat eine Dicke von 50 µm und die Schichtdicke der Al₂O₃-Schicht 7 liegt bei 300 µm. Bei der Mullitschicht 6 und der Al₂O₃-Schicht 7 handelt es sich um mechanisch stabile, rissfreie, durch Flammspritzen erzeugte Schichten, die einzelne Lagen einer Stabilisierungsschicht im Sinne dieser Erfindung bilden.

Nachfolgend wird ein weiteres Ausführungsbeispiel für das erfindungsgemäße Verfahren anhand der Herstellung des Rohres gemäß Figur 2 näher erläutert.

In einem ersten Verfahrensschritt wird kristalline Körnung aus natürlichem Quarz mit einer Komgröße von 90 bis 315 µm wird mittels Heißchlorierung gereinigt und in eine rohrförmige Metallform eingefüllt, die um ihre Längsachse rotiert. Unter der Wirkung der Zentrifugalkraft und Zuhilfenahme einer Schablone wird aus der Schüttung an der Innenwandung der Metallform ein rotationssymmetrischer Hohlzylinder geformt. Der Hohlzylinder hat in der Schüttung eine Schichtdicke von ca. 100 mm und eine Innenbohrung in Form einer Durchgangsbohrung mit einem Innendurchmesser von etwa 180 mm. Durch die Zentrifugalkraft wird die Schüttung vor Durchführung der nachfolgenden Verfahrensschritte leicht verfestigt.

In einem zweiten Verfahrensschritt wird der mechanisch vorverdichtete Hohlzylinder mittels eines Lichtbogens von der Innenbohrung aus zonenweise geschmolzen. Hierzu wird von einem Ende des Hohlzylinders beginnend ein Elektrodenpaar in die Innenbohrung eingeführt und zum gegenüberliegenden Ende des Hohlzylinders hin kontinuierlich bewegt. Durch die Temperatur des Lichtbogens wird die Körnung geschmolzen. An der Innenwandung des Hohlzylinders wird eine Maximaltemperatur von über 2100°C erreicht. Dabei bildet sich eine nach außen, in Richtung der Metallform fortschreitende Schmelzfront. Das Erschmelzen wird beendet bevor die Schmelzfront die Metallform erreicht.

Das so erzeugte Rohr aus opakem Quarzglas wird der Metallform entnommen, abgeschliffen und anschließend in Flusssäure geätzt und in einem Heißumformschritt unter Reduktion der Wandstärke elongiert (dritter Verfahrensschritt). Nach dem Elongieren beträgt der Außendurchmesser 245 mm und der Innendurchmesser 233 mm. Die Außenmantelfläche wird mit gefrorenen CO₂-Pellets abgestrahlt und dadurch eine Oberflächenrauhigkeit Rₐ von 50 µm erzeugt. Dieses Rohr bildet bei dem Quarzglasrohr 4 gemäß Figur 2 die Basisschicht 5 aus opakem Quarzglas. Gerade bei derartig dünnwandigen Rohren wie bei diesem Ausführungsbeispiel wirkt sich die Stabilisierungsschicht besonders vorteilhaft aus.

In einem vierten Verfahrensschritt wird das so vorbehandelte Rohr mittels Flammspritzen mit der Mullitschicht 6 versehen. Die Beschichtung erfolgt analog zu der oben anhand Figur 1 näher erläuterten Verfahrensweise zur Herstellung der Al₂O₃-Schicht 3 wobei jedoch eine konventionelle Pulver-Flammspritztechnologie eingesetzt wird. Hierbei wird das Mullitpulver mittels einer Pulverfördereinheit mit einem Fördergas in eine Acetylen-Sauerstoffflamme aufgeschmolzen und durch die bei der Verbrennung entstehende Ausdehnung des Acetylen-Sauerstoffgemischs beschleunigt und auf die zu beschichtende Rohroberfläche geschleudert. Die so erzeugte Mullitschicht 6 ist homogen und rissfrei und zeichnet sich durch hohe mechanische Festigkeit aus.

In einem weiteren Verfahrensschritt wird auf der Mullitschicht 6 nach dem gleichen Beschichtungsverfahren (Flammspritzen unter Einsatz einer Acetylen-Sauerstoffflamme) die äußere Al₂O₃-Schicht 7 aufgebracht. Die Mullitschicht 6 bewirkt einen allmählichen Übergang des Ausdehnungskoeffizienten des opaken Quarzglases der Basisschicht 5 und der Al₂O₃-Schicht 7 und trägt damit zu einer hohen mechanischen Stabilität der Stabilisierungsschicht insgesamt bei.

**Figur 3** zeigt schematisch eine Vorrichtung, die zum Aufbringen einer Stabilisierungsschicht auf der Außenwandung eines Quarzglastiegels 31 auf einer um die Mittelachse 32 des Quarzglastiegels 31rotierbaren Spannvorrichtung 33 montiert. Außerhalb des Quarzglastiegels 31 wird eine Flammspritzdüse 34an einem in horizontaler und in vertikaler Richtung beweglichen Halter 35 fixiert. Zusätzlich ist die Flammspritzdüse 34 kippbar, so das sie jede Position der Tiegel-Außenwandung erreichen kann. Die Flammspritzdüse 34 ist mit einer Zuführung 36 für Acetylen und Sauerstoff und mit einer Zuleitung 37 für Al₂O₃-Pulver verbunden. Mittels der Flammspritzdüse 34 wird auf der Außenwandung des um die Mittelachse 33 rotierenden Quarzglastiegels 31 die Stabilisierungsschicht 38 aufgebracht. Mittels der in Figur 3 schematisch dargestellten Vorrichtung können ohne großen Aufwand Stabilisierungsschichten vorgegebener Dicke und aus unterschiedlichen Ausgangsmaterialien erzeugt werden.

## Patentansprüche

1. Quarzglastiegel mit hoher thermischer Stabilität, umfassend eine Rohform, von der mindestens ein Teil ihrer Außenoberfläche mit einer Stabilisierungsschicht versehen ist, die eine höhere Erweichungstemperatur als Quarzglas aufweist, **dadurch gekennzeichnet, dass** die Stabilisierungsschicht (3; 6; 7; 38) sich in ihrer chemischen Zusammensetzung von Quarzglas unterscheidet, und dass sie durch thermisches Spritzen erzeugt ist.

2. Quarzglastiegel nach Anspruch 1, **dadurch gekennzeichnet, dass** die Stabilisierungsschicht (3; 6; 7; 38) Oxide, Silikate, Phosphate und/oder Silizide enthält.

3. Quarzglastiegel nach Anspruch 2, **dadurch gekennzeichnet, dass** die Stabilisierungsschicht (3; 6; 7; 38) Al₂O₃ und/oder Mullit, Hafniumoxid, Tantaloxid, Zirkonsilikat, Seltenerd-Phosphate, Seltenerd-Oixde enthält.

4. Quarzglastiegel nach einem der vorhergehenden Ansprüche, **dadurch gekennzeichnet, dass** die Stabilisierungsschicht (3; 6; 7; 38) eine Schichtstärke im Bereich zwischen 50 µm und 1000 µm aufweist.

5. Quarzglastiegel nach einem der vorhergehenden Ansprüche, **dadurch gekennzeichnet, dass** die Stabilisierungsschicht mehrere, aufeinanderfolgende Lagen (6; 7) unterschiedlicher chemischer Zusammensetzung umfasst.

6. Quarzglastiegel nach Anspruch 5, **dadurch gekennzeichnet, dass** die Stabilisierungsschicht eine Lage (6) aus Mullit und eine weiter außen liegende Lage (7) aus Al₂O₃ aufweist.

7. Verfahren zur Herstellung eines Quarzglastiegels mit hoher thermischer Stabilität, indem eine Rohform des Quarzglastiegels erzeugt und mindestens ein Teil der Außenoberfläche davon mit einer Stabilisierungsschicht, die eine höhere Erweichungstemperatur als Quarzglas aufweist, versehen wird, **dadurch gekennzeichnet, dass** eine sich in ihrer chemischen Zusammensetzung von Quarzglas unterscheidende Stabilisierungsschicht (3; 6; 7; 38) durch thermisches Spritzen aufgebracht wird.

8. Verfahren nach Anspruch 7, **dadurch gekennzeichnet, dass** die Stabilisierungsschicht (3; 6; 7; 38) auf einer Oberfläche mit einer mittleren Rauhtiefe Rₐ von mindestens 10 µm aufgebracht wird.

9. Verfahren nach einem der vorhergehenden Verfahrensansprüche, **dadurch gekennzeichnet, dass** die Stabilisierungsschicht (3) durch Plasmaspritzen erzeugt wird.

10. Verfahren nach einem der Ansprüche 7 bis 9, **dadurch gekennzeichnet, dass** die Stabilisierungsschicht (6; 7; 38) durch Flammspritzen erzeugt wird.

11. Verfahren nach einem der vorhergehenden Verfahrensansprüche, **dadurch gekennzeichnet, dass** eine hochschmelzende Oxide und/oder Silikate, Phosphate, Silizide enthaltende Stabilisierungsschicht (3; 6; 7; 38) erzeugt wird.

12. Verfahren nach Anspruch 11, **dadurch gekennzeichnet, dass** die Stabilisierungsschicht (3; 6; 7; 38) Al₂O₃ und/oder Mullit, Hafniumoxid, Tantaloxid, Zirkonsilikat, Seltenerd-Phosphate, Seltenerd-Oxide enthält.

13. Verfahren nach einem der vorhergehenden Verfahrensansprüche, **dadurch gekennzeichnet, dass** eine Stabilisierungsschicht (3; 6; 7; 38) mit einer Schichtstärke im Bereich zwischen 50 µm und 1000 µm erzeugt wird.

14. Verfahren nach einem der vorhergehenden Verfahrensansprüche, **dadurch gekennzeichnet, dass** zur Erzeugung der Stabilisierungsschicht ein Kompositpulver eingesetzt wird.

15. Verfahren nach einem der vorhergehenden Verfahrensansprüche, **dadurch gekennzeichnet, dass** zur Erzeugung der Stabilisierungsschicht mindestens zwei Ausgangsmaterialien mit unterschiedlicher chemischer Zusammensetzung eingesetzt werden.

16. Verfahren nach einem der vorhergehenden Verfahrensansprüche, **dadurch gekennzeichnet, dass** zum Erzeugen der Stabilisierungsschicht mehrere aufeinanderfolgende Lagen (6; 7) mit unterschiedlicher chemischer Zusammensetzung auf die Außenoberfläche aufgebracht werden.

17. Verfahren nach Anspruch 15, **dadurch gekennzeichnet, dass** eine Mullitschicht (6) erzeugt wird, die von einer Al₂O₃-Schicht (7) umgeben ist.

## Claims

1. A quartz glass crucible of a high thermal stability, comprising a base form of which at least a part of the outer surface thereof is provided with a stabilization layer having a higher softening temperature than quartz glass, **characterized in that** said stabilization layer (3; 6; 7; 38) differs in its chemical composition from quartz glass, and that it is produced by thermal spraying.

2. The quartz glass crucible according to claim 1, **characterized in that** said stabilization layer (3; 6, 7; 38) contains oxides, silicates, phosphates and/or silicides.

3. The quartz glass crucible according to claim 2, **characterized in that** said stabilization layer (3, 6; 7; 38) contains Al₂O₃ and/or mullite, hafnium oxide, tantalum oxide, zirconium silicate, rare-earth phosphates, rare-earth oxides.

4. The quartz glass crucible according to any one of the preceding claims, **characterized in that** said stabilization layer (3, 6, 7; 38) has a layer thickness ranging from 50 µm to 1000 µm.

5. The quartz glass crucible according to any one of the preceding claims, **characterized in that** said stabilization layer comprises a plurality of successive layers (6;7) of a different chemical composition.

6. The quartz glass crucible according to claim 5, **characterized in that** said stabilization layer includes a layer (6) of mullite and a further outer layer (7) of Al₂O₃.

7. A method of producing a quartz glass crucible of a high thermal stability, wherein a base form of said quartz glass crucible is produced and at least a part of the outer surface thereof is provided with a stabilization layer having a higher softening temperature than quartz glass, **characterized in that** a stabilization layer (3; 6; 7; 38) differing in its chemical composition from quartz glass is applied by thermal spraying.

8. A method according to claim 7, **characterized in that** said stabilization layer (3; 6; 7; 38) is applied to a surface having an average surface roughness Rₐ of at least 10 µm.

9. The method according to any one of the preceding method claims, **characterized in that** said stabilization layer (3) is produced by plasma spraying.

10. The method according to any one of claims 7 to 9, **characterized in that** said stabilization layer (6; 7; 38) is produced by flame spraying.

11. The method according to any one of the preceding method claims, **characterized in that** a stabilization layer (3, 6; 7; 38) containing high-melting oxides and/or silicates, phosphates, silicides is produced.

12. The method according to claim 11, **characterized in that** said stabilization layer (3, 6; 7, 38) contains Al₂O₃ and/or mullite, hafnium oxide, tantalum oxide, zirconium silicate, rare-earth phosphates, rare-earth oxides.

13. The method according to any one of the preceding method claims, **characterized in that** a stabilization layer (3, 6; 7, 38) is provided with a layer thickness ranging from 50 µm to 1000 µm.

14. The method according to any one of the preceding method claims, **characterized in that** a composite powder is used for producing said stabilization layer.

15. The method according to any one of the preceding method claims, **characterized in that** at least two starting materials of a different chemical composition are used for producing said stabilization layer.

16. The method according to any one of the preceding method claims, **characterized in that** a plurality of successive layers (6; 7) of a different chemical composition are applied to said outer surface for producing said stabilization layer.

17. The method according to claim 15, **characterized in that** a mullite layer (6) is produced which is surrounded by an Al₂O₃ layer (7).

## Revendications

1. Creuset en verre de quartz avec une stabilité thermique élevée, comprenant une ébauche dont au moins une partie de sa surface extérieure est munie d'une couche de stabilisation qui présente une température de ramollissement plus élevée que le verre de quartz, **caractérisé en ce que** la couche de stabilisation (3; 6; 7; 38) se différencie dans sa composition chimique du verre de quartz et **en ce qu'**elle est produite par injection thermique

2. Creuset en verre de quartz selon la revendication 1, **caractérisé en ce que** la couche de stabilisation (3; 6; 7; 38) contient des oxydes, des silicates, des phosphates et/ou des siliciures.

3. Creuset en verre de quartz selon la revendication 2, **caractérisé en ce que** la couche de stabilisation (3; 6; 7; 38) contient de l'Al₂O₃ et/ou de la mullite, de l'oxyde d'hafnium, de l'oxyde de tantale, du silicate de zirconium, du phosphate à terres rares et des oxydes à terres rares.

4. Creuset en verre de quartz selon l'une des revendications précédentes, **caractérisé en ce que** la couche de stabilisation (3; 6; 7; 38) présente une épaisseur comprise entre 50 µm et 100 µm.

5. Creuset en verre de quartz selon l'une des revendications précédentes, **caractérisé en ce que** la couche de stabilisation comprend plusieurs couches consécutives (6; 7) de composition chimique différente.

6. Creuset en verre de quartz selon la revendication 5, **caractérisé en ce que** la couche de stabilisation présente une couche (6) de mullite et une autre couche (7) plus à l'extérieur de Al2O₃.

7. Procédé pour la fabrication d'un creuset de verre de quartz avec une stabilité thermique élevée dans lequel une ébauche du creuset en verre de quartz est produite et au moins une partie de la surface externe est munie d'une couche de stabilisation qui présente une température de ramollissement plus élevée, **caractérisé en ce qu'**une couche de stabilisation (3; 6; 7; 38), dont la composition chimique est différente de celle du verre de quart est appliquée par projection à chaud.

8. Procédé selon la revendication 7, **caractérisé en ce que** la couche de stabilisation (3; 6; 7; 38) est appliquée sur une surface avec une profondeur de rugosité moyenne Ra d'au moins 10µm.

9. Procédé selon l'une des revendications précédentes, **caractérisé en ce que** la couche de stabilisation (3) est générée par projection au plasma.

10. Procédé selon l'une des revendications 7 à 9, **caractérisé en ce que** la couche de stabilisation (6; 7; 38) est générée par projection à la flamme.

11. Procédé selon l'une des revendications précédentes, **caractérisé en ce qu'**une couche de stabilisation à fusion élevée contenant des siliciures, des oxydes et/ou des silicates et des phosphates, est générée.

12. Procédé selon la revendication 11, **caractérisé en ce que** la couche de stabilisation (3; 6; 7; 38) contient de l'Al₂O₃ et/ou de la mullite, de l'oxyde d'hafnium, de l'oxyde de tantale, du silicate de zirconium, du phosphate à terres rares et des oxydes à terres rares.

13. Procédé selon l'une des revendications précédentes, **caractérisé en ce qu'**une couche de stabilisation (3; 6; 7; 38) présente une épaisseur comprise entre 50 µm et 100 µm.

14. Procédé selon l'une des revendications précédentes, **caractérisé en ce que** pour la fabrication d'une couche de stabilisation, il est utilisé de la poudre de composite.

15. Procédé selon l'une des revendications précédentes, **caractérisé en ce que** pour la fabrication d'une couche de stabilisation, il est utilisé au moins deux matériaux d'origine avec une composition chimique différente.

16. Procédé selon l'une des revendications précédentes, **caractérisé en ce que** pour la fabrication d'une couche de stabilisation, plusieurs couches consécutives (6; 7) de composition chimiques différentes sont appliquées sur la surface externe.

17. Procédé selon la revendication 15, **caractérisé en ce qu'**une couche de mullite (6) entourée d'une couche de Al₂O₃ (7) est produite.
